(19) Europäisches Patentamt

European Patent Office

Office européen des brevets

(11) **EP 0 990 716 B1**

(12) **FASCICULE DE BREVET EUROPEEN**

(45) Date de publication et mention
de la délivrance du brevet:
**20.03.2002  Bulletin 2002/12**

(51) Int Cl.⁷: **C23C 14/08**, C23C 16/40,
C23C 14/06, C23C 16/30,
C23C 4/10

(21) Numéro de dépôt: **99402384.4**

(22) Date de dépôt: **30.09.1999**

(54) **Revetement de barrière thermique**

Wärmedämmschicht

Thermal barrier coating

(84) Etats contractants désignés:
**AT BE CH CY DE DK ES FI FR GB GR IE IT LI LU
MC NL PT SE**

(30) Priorité:  **02.10.1998  FR 9812342**

(43) Date de publication de la demande:
**05.04.2000  Bulletin 2000/14**

(73) Titulaire: **SNECMA MOTEURS
75015 Paris (FR)**

(72) Inventeurs:
• **Alperine, Serge Alexandre
  75004 Paris (FR)**
• **Gerzdev, Serge
  123364 Moscou (RU)**
• **Jaslier, Yann Philippe
  77000 Melun (FR)**
• **Tamarine, Yuri
  111555 Moscou (RU)**

(56) Documents cités:
**EP-A- 0 799 904      FR-A- 2 737 504
US-A- 4 248 940**

**Description**

L'invention concerne un revêtement de barrière thermique à faible conductivité thermique, une pièce métallique protégée par ce revêtement et un procédé de dépôt de ce revêtement.

Les constructeurs de moteurs à turbine, terrestres et aéronautiques, sont confrontés depuis plus de trente ans à des impératifs d'augmentation du rendement des turbomachines, de diminution de leur consommation spécifique en carburant et des émissions polluantes de types $CO_x$, $SO_x$, $NO_x$ et imbrûlés. Une des façons de répondre à ces impératifs consiste à se rapprocher de la stoéchiométrie de combustion du carburant et donc à augmenter la température des gaz sortant de la chambre de combustion et impactant les premiers étages de turbine.

Corrélativement, il s'est avéré nécessaire de rendre les matériaux de la turbine compatibles avec cette élévation de température des gaz de combustion. Une des solutions retenues consiste à améliorer les techniques de refroidissement des aubes de turbine. Cette évolution implique une forte augmentation de la technicité et du coût de réalisation des pièces. Une autre solution consiste à faire évoluer la réfractarité des matériaux utilisés (température limite d'usage et durée de vie en fluage et en fatigue). Cette solution a été mise en oeuvre lors de l'apparition des superalliages à base de nickel et/ou de cobalt. Elle a connu une évolution technique considérable par le passage des superalliages équiaxes aux superalliages monocristallins (gain de 80 à 100°C en fluage). Cette voie ne peut aujourd'hui être exploitée qu'à des coûts de développement importants (superalliages dits de troisième génération, devant permettre un gain supplémentaire en fluage de 20°C environ). Au-delà un nouveau changement de famille de matériau s'impose.

Une alternative à ce changement de famille de matériaux consiste à déposer sur les pièces chaudes en superalliages un revêtement isolant thermique appelé barrière thermique. Ce revêtement de céramique permet sur une pièce refroidie de créer, en régime permanent de fonctionnement, un gradient thermique au travers de la céramique dont l'amplitude totale peut dépasser 200°C. La température de fonctionnement du métal sous-jacent se trouve diminuée en proportion avec une incidence considérable sur le volume d'air de refroidissement nécessaire, la durée de vie de la pièce et la consommation spécifique du moteur.

Le revêtement de céramique peut être déposé sur la pièce à revêtir en utilisant des procédés divers appartenant pour la plupart d'entre eux à deux familles distinctes: les revêtements projetés et les revêtements déposés par voie physique en phase vapeur. D'autres procédés de dépôts de type dépôt chimique en phase vapeur (CVD) assisté par plasma peuvent également être utilisés.

Pour les revêtements projetés, un dépôt d'oxyde à base de zircone est effectué par des techniques apparentées à la projection plasma. Le revêtement est constitué d'un empilement de gouttelettes de céramique fondues puis trempées par choc, aplaties et empilées de façon à former un dépôt imparfaitement densifié d'une épaisseur comprise entre 50 µm et lmm. Une des caractéristiques de ce type de revêtement est une rugosité intrinsèquement élevée (La rugosité Ra est comprise typiquement entre 5 et 35 µm). Le mode de, dégradation en service associé le plus souvent à ce revêtement est caractérisé par la propagation lente d'une fissure dans la céramique parallèlement à l'interface céramique/métal.

Dans le cas des revêtements déposés par voie physique en phase vapeur, le problème est sensiblement différent. Un tel dépôt peut être réalisé par évaporation sous bombardement électronique. Sa caractéristique principale est que le revêtement est constitué d'un assemblage de colonnettes très fines (entre 0,2 et 10 µm typiquement) orientée sensiblement perpendiculairement à la surface à revêtir. L'épaisseur d'un tel revêtement peut être comprise entre 20 et 600 µm. Un tel assemblage présente la propriété intéressante de reproduire sans l'altérer l'état de surface du substrat recouvert. En particulier, dans le cas d'aubes de turbines, des rugosités finales largement inférieures au micromètre peuvent être obtenues, ce qui est très avantageux pour les propriétés aérodynamiques de l'aube. Une autre conséquence de la structure dite colonnaire des dépôts de céramique par voie physique en phase vapeur, est que l'espace situé entre les colonnettes permet au revêtement d'accommoder de manière très efficace les contraintes de compression subies en service à cause du différentiel de dilatation avec le substrat en superalliage. Dans ce cas, des durées de vie élevées en fatigue thermique à haute température peuvent être atteintes et la rupture du revêtement a lieu au voisinage de l'interface sous-couche/céramique.

Les techniques de dépôt chimique en phase vapeur produisent des revêtements dont la morphologie est colonnaire et sensiblement équivalente à celle des dépôts effectués par voie physique en phase vapeur. Dans les techniques de dépôt chimique ou physique en phase vapeur, la formation d'oxyde résulte d'une réaction moléculaire entre des atomes ou des ions métalliques et l'oxygène.

Les revêtements de barrière thermique sont composés de mélange d'oxydes, le plus souvent à base de zircone. Cet oxyde constitue un compromis intéressant entre un matériau possédant une conductivité thermique assez faible et un coefficient de dilatation relativement élevé, proche de celui des alliages à base de nickel et/ou de cobalt sur lesquels on souhaite le déposer. Une des compositions de céramique donnant le plus de satisfaction est la zircone totalement ou partiellement stabilisée par un oxyde tel que par exemple par l'oxyde d'yttrium : $ZrO_2$ + 6 à 8 % massique d'$Y_2O_3$. Le rôle de l'oxyde d'yttrium est de stabiliser la variété allotropique cubique C et/ou tétragonale non transformable t' de la zircone, et d'éviter ainsi des transitions de phases de type martensitique lors des excursions entre la température ambiante et la température de service élevée de la pièce.

La fonctionnalité première d'un revêtement de barrière thermique est de ralentir les échanges de chaleur entre un milieu extérieur composés de gaz chauds et la pièce métallique recouverte, ladite pièce métallique étant le plus souvent elle-même refroidie par circulation forcée de gaz froids. Les échanges de chaleur entre le revêtement céramique et le métal sous-jacent peuvent être conductifs et, dans une moindre mesure, radiatifs. C'est la conductivité thermique du revêtement céramique qui mesure son efficacité pour ralentir la conduction de la chaleur. Les échanges radiatifs, quant à eux, sont pour l'essentiel régis par la transparence ou semi-transparence du revêtement au rayonnement incident mais l'effet de semi-transparence de la céramique est du second ordre par rapport à l'effet de conduction dans les processus de transport de la chaleur. La conductivité thermique est donc le paramètre le plus pertinent qu'il convient de régler pour diminuer l'amplitude du transport de chaleur dans les revêtements.

Il existe plusieurs méthodes permettant de diminuer la conductivité thermique du revêtement. Ces méthodes dérivent du fait que les revêtements de barrière thermique sont des couches céramiques poreuses et que la conductivité thermique du revêtement est celle d'un assemblage hétérogène de deux milieux conducteurs de la chaleur; ces deux milieux sont le matériau céramique lui-même, de conductivité intrinsèque $\lambda_{intr}$, et les pores ou microfissures du revêtement dont la conductivité est proche de celle de l'air qui les emplit en conditions de service.

La conductivité effective du revêtement $\lambda_{réel}$, est comprise entre $\lambda_{intr}$ et la conductivité de l'air $\lambda_{air}$. On peut en fait écrire que $\lambda_{réel}$ est une fonction complexe de $\lambda_{intr}$, $\lambda_{air}$ et de la morphologie du revêtement.

Une première solution pour obtenir un revêtement de faible conductivité thermique consiste, à utiliser une céramique dont la composition céramique est classique, par exemple de la zircone partiellement stabilisée par 6 à 8 % en poids d'oxyde d'yttrium, et à modifier la morphologie du revêtement, c'est à dire la proportion, la répartition et l'orientation des pores et microfissures du revêtement, ou bien l'arrangement de la matière sous forme de colonnes ou de strates, de façon à diminuer $\lambda_{réel}$. Il est possible de parvenir à ce résultat en modifiant les paramètres de dépôt du revêtement.

Une deuxième solution consiste à chercher, en modifiant la composition chimique du revêtement, à diminuer directement $\lambda_{intr}$, sans altérer sa morphologie, tout en conservant les autres propriétés du revêtement. C'est cette solution qui est mise en oeuvre dans la présente invention.

Le but de l'invention est de déterminer une nouvelle composition chimique permettant d'obtenir un revêtement de barrière thermique de faible conductivité thermique.

Pour cela, l'invention consiste à élaborer une composition de barrière thermique classique, par exemple de la zircone partiellement stabilisée par un oxyde et à y ajouter un autre élément métallique Me, cet élément métallique pouvant être introduit sous sa forme oxydée $Me_xO_y$, susceptible d'augmenter de façon significative la quantité de lacunes d'oxygène présentes dans le réseau cristallin de la zircone tout en préservant ses principales autres caractéristiques telles que, par exemple la nature des phases, le coefficient de dilatation, la réfractarité.

Selon l'invention, le revêtement de barrière thermique à faible conductivité thermique déposé sur un substrat en superalliage est caractérisé en ce qu'il comporte un mélange homogène d'oxydes ayant une composition contenant au moins une base de zircone, un oxyde stabilisant de la zircone et 0,5% à 12% en poids d'un élément métallique additionnel choisi parmi le nickel, le cobalt, le fer, ou un mélange de nickel, de cobalt et de fer.

Préférentiellement, la proportion de l'élément métallique additionnel dans le revêtement est comprise entre 1,5 et 5% en poids. L'élément métallique additionnel peut également être introduit sous sa forme oxydée.

Avantageusement, la composition du revêtement contient en outre 0,01% à 1% en poids, préférentiellement entre 0,02% et 0,1% en poids, de carbone.

L'invention concerne également une pièce métallique en superalliage revêtue, au moins en partie, par un revêtement céramique de type barrière thermique à faible conductivité thermique.

D'autres particularités et avantages de l'invention apparaîtront clairement dans la suite de la description donnée à titre d'exemple non limitatif et faite en regard des figures annexées qui représentent :

- la figure 1, un exemple comparatif de courbes d'évolution, en fonction de la température, de la conductivité thermique de différents revêtements réalisés selon l'art antérieur et selon l'invention

- la figure 2, un exemple comparatif de courbes d'évolution de la conductivité thermique de différents revêtements en fonction de la température, avant et après un recuit de 150 heures à 1100°C sous air.

Lors de la recherche d'une nouvelle composition chimique d'un revêtement céramique de type barrière thermique, nous avons constaté qu'en ajoutant un élément métallique additionnel ou un oxyde métallique, tel que par exemple le nickel, le cobalt, le fer, l'oxyde de nickel, l'oxyde de cobalt, un oxyde de fer, à une composition à base de zircone partiellement ou totalement stabilisée, nous obtenons un revêtement céramique à conductivité thermique abaissée.

Nous avons également constaté que l'adjonction de faibles quantités de carbone dans le revêtement, de 0,01 à 1 % en poids et préférentiellement de 0,02 à 0,1% en poids, a une incidence très appréciable sur la diminution de la conductivité thermique du revêtement. L'adjonction de carbone dans le revêtement a pour but de favoriser la cristallisation du revêtement d'oxyde sous une forme non-stoechiométrique. Ce résultat est obtenu grâce à des réactions solide/gaz au sein du revêtement telles que :

$$Me_xO_y + y\,C \rightarrow x\,Me + y\,CO \uparrow$$

ou bien

$$2\,Me_xO_y + y\,C \rightarrow 2x\,Me + y\,CO_2 \uparrow$$

Une quantité appréciable de CO ou de $CO_2$ peut être piégée dans le réseau cristallin de la céramique ainsi que dans les micropores de sa structure, contribuant ainsi à la réduction de la conductivité thermique.
Un revêtement selon l'invention peut donc être réalisé selon l'un des exemples 1 à 3 ci-dessous.

**Exemple 1:**

Une pièce en alliage réfractaire, préférentiellement en superalliage à base de nickel et/ou de cobalt, est utilisée comme substrat. Cette pièce est revêtue d'une sous-couche métallique selon un procédé connu dans l'état de l'art. Cette sous-couche peut être un alliage alumino-formeur résistant à l'oxydo-corrosion de type MCrAlY (M=Ni et/ou Co et/ou Fe) ou un aluminiure de nickel ou de cobalt, modifié ou non par l'adjonction de chrome et d'un ou plusieurs métaux précieux de la mine du platine choisis parmi le platine, le palladium, le ruthénium, l'iridium, l'osmium, le rhodium. Cette liste de sous-couches possibles n'est pas restrictive et n'est donnée qu'à titre d'exemple non limitatif. Ladite sous-couche peut être déposée sur ledit substrat par exemple par un procédé de projection thermique, un procédé d'évaporation sous faisceau d'électrons (EB-PVD) ou un procédé de type dépôt chimique en phase vapeur (CVD ou dépôt thermochimique).A titre indicatif, l'épaisseur de la sous-couche est comprise entre 30 et 250 µm, et préférentiellement entre 50 et 120 µm.
Le dépôt du revêtement céramique peut ensuite être réalisé dans une installation de dépôt par évaporation sous faisceau d'électrons. Pour cela, on mélange puis on fritte sous forme de barreau un mélange de poudres de zircone, d'oxyde d'yttrium et d'un élément métallique additionnel choisi parmi le nickel et/ou le cobalt et/ou le fer, cet élément métallique additionnel pouvant être introduit sous une forme oxydée, de façon à ce que la composition moyenne du barreau comporte une base en $ZrO_2$, 3 à 15% en poids de $Y_2O_3$ et 0,5 à 12%, préférentiellement de 1,5 à 5%, en poids de l'élément métallique additionnel.
La granulométrie initiale des poudres et les conditions de frittage du barreau (température, pression, durée) sont choisies de manière connue, de façon à obtenir un produit final apte à être évaporé dans une installation de dépôt par évaporation sous faisceau d'électrons. En particulier, on veille à ce que l'homogénéité macroscopique de la composition du barreau et le niveau de porosité résiduelle soient convenables (par exemple comprise entre 25% et 50%).
La pièce à recouvrir est introduite dans une enceinte de dépôt EBPVD préalablement chargée d'un barreau à évaporer tel que décrit ci-dessus. Après mise sous vide de l'enceinte et préchauffage de la pièce, on focalise, de manière connue, le ou les faisceaux d'électrons de l'enceinte sur la partie dudit barreau émergeant du creuset, de façon à en vaporiser la surface qui se condense sur la pièce positionnée en regard.
Les chaleurs massiques d'évaporation des différents éléments présents dans le barreau étant peu différentes, on obtient dans la phase gazeuse un mélange homogène des différentes espèces (zirconium, yttrium, nickel et/ou cobalt, et/ou fer, oxygène) dans des proportions sensiblement identiques à celles réalisées dans le barreau. On constate par analyse que la composition du revêtement correspond bien à la composition moyenne du barreau indiquée ci-dessus.
On remarque également que le mélange des espèces dans la phase vapeur assure une parfaite homogénéité dans la composition du revêtement.
On maintient la pièce en regard de la vapeur provenant du barreau durant un temps suffisant pour construire à sa surface un revêtement d'épaisseur comprise entre 20 et 400 µm, préférentiellement entre 70 et 250 µm. Le revêtement obtenu montre une structure composée de la juxtaposition de colonnettes sensiblement perpendiculaires à la surface de la pièce, comme il est généralement observé lors de dépôts de zircone par le procédé EBPVD. Il est à noter que le revêtement montre une couleur noire ou gris foncé, alors qu'un revêtement réalisé selon l'art antérieur, c'est à dire dans des conditions identiques mais en l'absence de nickel, de cobalt et de fer dans le barreau (et donc dans le revêtement) a une couleur blanche, jaune pale ou gris très clair.

L'étude de la structure cristallographique du revêtement par diffraction des rayons X montre qu'il est composé pour l'essentiel de la phase t' tétragonale et métastable de la zircone, avec toutefois de très petites quantités d'oxyde de nickel et/ou de cobalt et/ou de fer.

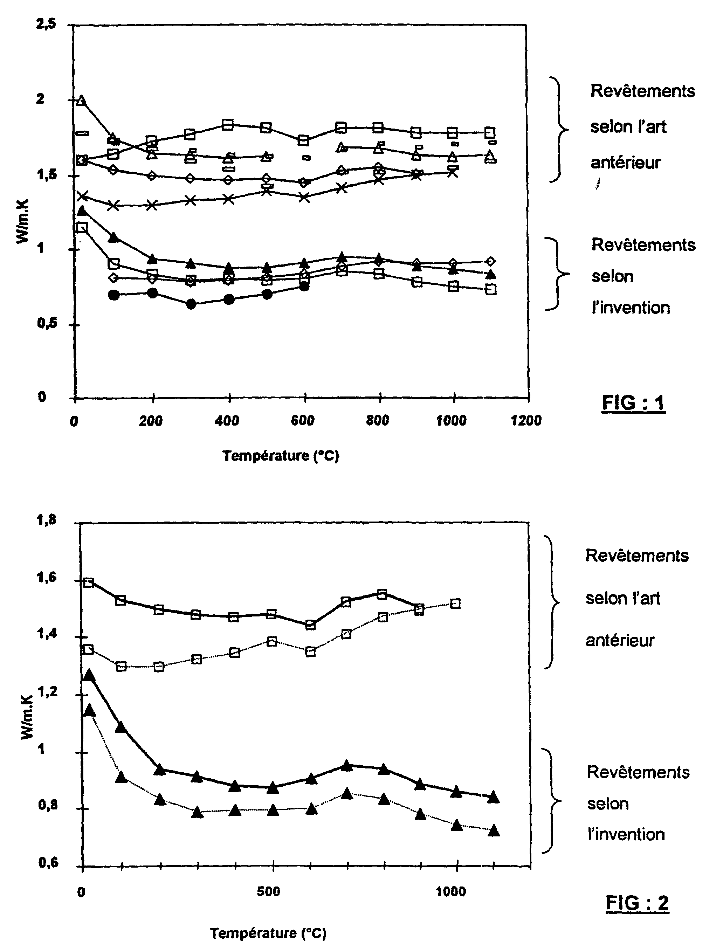

Si l'on revêt de cette façon des échantillons d'alliages destinés à la mesure de la conductivité thermique du revêtement et que l'on compare cette grandeur à celle mesurée sur des échantillons identiques revêtus selon l'art antérieur, c'est à dire en l'absence de nickel, de cobalt et de fer dans le barreau (et donc dans le revêtement), on obtient les résultats représentés sur la figure 1. Sur cette figure 1 on a représenté la valeur de la conductivité thermique de revêtements mesurée depuis la température ambiante jusqu'à 1100°C pour une série de revêtements selon l'invention d'une part et pour une série de revêtements commerciaux correspondant à l'art antérieur d'autre part. On peut voir sans ambiguïté que les revêtements selon l'invention permettent de diviser la conductivité thermique de la barrière thermique d'un facteur proche de deux par rapport à l'art antérieur, conformément à l'effet recherché.

On a par ailleurs étudié l'influence d'un vieillissement des revêtements à haute température sur leur conductivité thermique. Ce point est important pour s'assurer que les valeurs de conductivité peuvent être pérennes lors du fonctionnement des pièces revêtues à haute température. Pour ce faire des échantillons selon l'invention et selon l'art antérieur ont subi des recuits de 150 heures environ à 1100°C sous air avant de subir des mesures de conductivité. Les résultats sont représentés sur la figure 2. Les symboles triangulaires représentent les échantillons selon l'invention; les symboles carrés représentent les échantillons selon l'art antérieur. Les courbes en trait pointillés représentent les échantillons bruts de dépôt. Les courbes en trait plein représentent les échantillons vieillis. On constate que dans tous les cas la conductivité thermique remonte légèrement lors du recuit, mais que cet effet n'est pas plus marqué pour les revêtements selon l'invention que pour ceux selon l'art antérieur. L'avantage des revêtements selon l'invention reste manifeste même après vieillissement.

Exemple 2:

On procède comme dans l'exemple 1, dans le but d'obtenir un revêtement céramique de la composition suivante:

| Composant | % poids |
|---|---|
| $ZrO_2$ | base |
| $Y_2O_3$ | 3-15 % |
| Ni et/ou Co et/ou Fe | 0,5 à 12 % (préférentiellement de 1,5 à 5 %) |
| Carbone | 0,01 à 1 % (préférentiellement 0,02 à 0,1%) |

L'adjonction de carbone dans le revêtement, a pour but de favoriser la cristallisation du revêtement d'oxyde sous une forme non-stoechiométrique.

L'ajout de carbone dans le revêtement peut, par exemple, être réalisé par voie liquide à partir du barreau comme décrit dans l'exemple 1, en ayant soin d'utiliser comme liant des poudres céramiques avant frittage, un solvant au moins partiellement organique riche en carbone (tel qu'un alcool polyvinylique). Lors du frittage des poudres à température modérée une partie du solvant reste présent sous la forme de résidus carbonés, piégés entre les grains de poudre céramique. Ces particules de carbone sont ensuite évaporées avec les oxydes lors de la constitution du revêtement et une partie du carbone se condense sur la pièce pendant le dépôt. On ajuste la quantité de solvant organique initialement utilisée pour la fabrication du barreau ainsi que les conditions de frittage du barreau de façon à obtenir la teneur de carbone résiduelle souhaitée dans le dépôt. Pour la réalisation d'un tel dépôt, on utilise de préférence une enceinte dans laquelle aucune adjonction d'oxygène durant le dépôt n'est effectuée.

Altervativement, il est possible d'introduire la quantité désirée de carbone dans le revêtement en introduisant dans l'enceinte de dépôt, un léger flux gazeux contenant au moins un gaz précurseur du carbone susceptible d'être décomposé par craquage. A titre non limitatif on peut citer parmi de tels gaz : le méthane, l'éthane, le butane, le propane et leurs équivalents dans les familles des alcènes et des alcynes. Ce gaz précurseur du carbone peut être dilué dans un gaz porteur afin d'ajuster le débit introduit selon la quantité de carbone que l'on souhaite incorporer au revêtement céramique.

Les revêtements obtenus selon cet exemple présentent des caractéristiques cristallographiques similaires à celles des dépôts réalisés selon l'exemple 1. La conductivité thermique de tels dépôts est encore inférieure à celle obtenue dans l'exemple précédent.

Exemple 3

On utilise un substrat et une sous-couche de protection contre l'oxydo-corrosion tels que décrits dans l'exemple 1.

Le revêtement céramique est réalisé par projection plasma. Pour cela, on utilise des poudres céramiques dont la composition est :

| Composant | % poids |
|---|---|
| $ZrO_2$ | base |
| $Y_2O_3$ | 3-15 % |
| Ni et/ou Co et/ou Fe | 0,5 à 12 % (préférentiellement de 1,5 à 5 %) |

Contrairement aux deux exemples précédents, il ne suffit pas d'utiliser un mélange de poudres des différents oxydes et il est nécessaire d'utiliser des poudres dites préalliées telles que la composition de chaque grain de poudre soit sensiblement égale à la composition nominale ci-dessus. A titre d'exemple non limitatif, de telles poudres peuvent être obtenues de manière connue, par des procédés d'atomisation-séchage suivis ou non d'un traitement thermique de consolidation, en four ou par plasma inductif, par les procédés de type fusion-broyage ou par des procédés sol-gels.

On réalise ensuite, par projection plasma un dépôt céramique isolant de composition sensiblement égale à la composition nominale de la poudre. Le revêtement céramique obtenu est un revêtement de type barrière thermique dont la conductivité thermique est très basse, pouvant atteindre 0,5 W/m.K à 1000°C.

## Revendications

1. Revêtement de barrière thermique à faible conductivité thermique déposé sur un substrat en superalliage, **caractérisé en ce qu'**il comporte un mélange homogène d'oxydes ayant une composition contenant, au moins, une base de zircone, un oxyde stabilisant de la zircone et 0,5% à 12% en poids d'un élément métallique additionnel choisi parmi le nickel, le cobalt, le fer ou un mélange de nickel et/ou de cobalt et/ou de fer et qu'il est déposé par EB-PVD.

2. Revêtement selon la revendication 1, **caractérisé en ce que** la proportion d'élément métallique additionnel dans le revêtement est comprise entre 1,5% et 5% en poids.

3. Revêtement selon l'une quelconque des revendications 1 ou 2, **caractérisé en ce que** l'élément métallique additionnel est introduit sous forme oxydée.

4. Revêtement selon l'une des revendications 1 à 3, **caractérisé en ce que** la composition du revêtement contient en outre 0,01% à 1% en poids de carbone.

5. Revêtement selon la revendication 4, **caractérisé en ce que** la proportion de carbone dans le revêtement est comprise entre 0,02% et 0,1% en poids.

6. Revêtement selon la revendication 1, **caractérisé en ce que** l'oxyde stabilisant de la zircone est de l'Yttrine.

7. Revêtement selon la revendication 6, **caractérisé en ce que** la proportion d'Yttrine est comprise entre 3% et 15%.

8. Revêtement selon la revendication 1, **caractérisé en ce que** le mélange homogène d'oxydes est déposé par un procédé d'évaporation sous faisceau d'électrons par évaporation d'un barreau ayant une composition comportant au moins une base en $Z_rO_2$, 3 à 15% en poids de $Y_2O_3$ et 0,5 à 12% en poids de Ni et/ou de Co et/ou de Fe et/ou de leurs oxydes.

9. Revêtement selon la revendication 8, **caractérisé en ce que** le barreau comporte en outre du carbone.

10. Revêtement selon la revendication 1, **caractérisé en ce que** le mélange homogène d'oxydes est déposé par projection thermique.

11. Revêtement selon la revendication 10, **caractérisé en ce que** le mélange homogène d'oxydes est déposé par projection plasma.

**12.** Revêtement selon la revendication 1, **caractérisé en ce que** le mélange homogène d'oxydes est déposé par un procédé de dépôt chimique en phase vapeur.

**13.** Revêtement selon la revendication 12, **caractérisé en ce que** le mélange homogène d'oxydes est déposé par un procédé de dépôt chimique en phase vapeur assisté par un plasma.

**14.** Revêtement selon l'une quelconque des revendications précédentes, **caractérisé en ce qu'**il comporte en outre une sous-couche métallique en alliage alumino-formeur interposée entre le substrat et le dépôt du mélange d'oxydes.

**15.** Revêtement selon la revendication 14, **caractérisé en ce que** la sous-couche est un dépôt d'aluminiure de nickel.

**16.** Revêtement selon la revendication 15, **caractérisé en ce que** l'aluminiure de nickel comporte au moins un métal choisi parmi le chrome, les métaux précieux de la mine du platine, l'yttrium, les terres rares.

**17.** Revêtement selon la revendication 16, **caractérisé en ce que** la sous-couche est un dépôt d'un alliage de type MCr AlY où M désigne au moins un métal choisi parmi le nickel, le cobalt, le fer.

**18.** Pièce métallique en superalliage, **caractérisé en ce qu'**elle comporte une surface revêtue au moins en partie par un revêtement de barrière thermique selon l'une quelconque des revendications précédentes.

**19.** Procédé de dépôt d'un revêtement de barrière thermique à faible conductivité thermique sur un substrat en superalliage, **caractérisé en ce qu'**il consiste :

- à mélanger et à fritter sous forme d'un barreau un mélange de poudres de zircone, d'oxyde stabilisant de la zircone, d'un élément métallique additionnel choisi parmi le nickel, le cobalt, le fer

- à introduire le substrat à revêtir dans une enceinte de dépôt EBPVD préalablement chargée du barreau

- à mettre l'enceinte sous vide, à préchauffer la pièce et à focaliser des faisceaux d'électrons sur le barreau de façon à vaporiser les éléments présents dans le barreau pour qu'ils se condensent sur le substrat à revêtir.

**20.** Procédé de dépôt selon la revendication 19, **caractérisé en ce que** lors de la réalisation du barreau, le mélange des poudres est réalisé en utilisant un liant comportant un solvant au moins partiellement organique riche en carbone.

**21.** Procédé de dépôt selon la revendication 20, **caractérisé en ce que** le solvant est un alcool polyvinylique.

**22.** Procédé de dépôt selon la revendication 19, **caractérisé en ce qu'**il consiste en outre à introduire dans l'enceinte de dépôt, au voisinage immédiat du substrat à revêtir, un flux gazeux contenant au moins un gaz précurseur du carbone susceptible d'être décomposé par craquage.

**23.** Procédé de dépôt selon la revendication 22, **caractérisé en ce que** le gaz précurseur du carbone est choisi parmi le méthane, l'éthane, le butane, le propane, un gaz de la famille des alcènes et/ou de la famille des alcynes.

**Patentansprüche**

**1.** Wärmedämmschicht mit niedriger spezifischer Wärmeleitfähigkeit, die auf ein Substrat aus Superlegierung aufgebracht ist,
    **dadurch gekennzeichnet,**
    **dass** sie aus einer homogenen Oxidemischung in einer Zusammensetzung besteht, die mindestens eine Basis aus Zirkonerde, ein die Zirkonerde stabilisierendes Oxid und 0,5 % bis 12 % Gewichtsanteile eines zusätzlichen metallenen Elements, und zwar Nickel, Kobalt oder Eisen, oder einer Mischung aus Nickel und/oder Kobalt und/oder Eisen, aufweist, und dass sie durch ein EB-PVD-Verfahren aufgebracht wird.

2. Wärmedämmschicht nach Anspruch 1,
    **dadurch gekennzeichnet,**
    **dass** der Anteil des zusätzlichen metallenen Elements in der Beschichtung zwischen 1,5 % und 5 % Gewichtsanteilen beträgt.

3. Wärmedämmschicht nach einem der Ansprüche 1 oder 2,
    **dadurch gekennzeichnet,**
    **dass** das zusätzliche metallene Element in oxidierter Form beigegeben wird.

4. Wärmedämmschicht nach einem der Ansprüche 1 bis 3,
    **dadurch gekennzeichnet,**
    **dass** die Zusammensetzung der Wärmedämmschicht ferner 0,01 % bis 1 % Gewichtsanteile Kohlenstoff enthält.

5. Wärmedämmschicht nach Anspruch 4,
    **dadurch gekennzeichnet,**
    **dass** der Anteil Kohlenstoff in der Wärmedämmschicht zwischen 0,02 % und 0,1 % Gewichtsanteilen beträgt.

6. Warmedämmschicht nach Anspruch 1,
    **dadurch gekennzeichnet,**
    **dass** es sich bei dem die Zirkonerde stabilisierenden Oxid um Yttriumoxid handelt.

7. Wärmedämmschicht nach Anspruch 6,
    **dadurch gekennzeichnet,**
    **dass** der Anteil Yttriumoxid zwischen 3 % und 15 % beträgt.

8. Wärmedämmschicht nach Anspruch 1,
    **dadurch gekennzeichnet,**
    **dass** die homogene Oxidemischung mit einem Aufdampfungsverfahren unter dem Elektronenstrahl aufgebracht wird, indem ein Stab verdampft wird, dessen Zusammensetzung mindestens eine Basis aus $ZrO_2$, 3 % bis 15 % Gewichtsanteile $Y_2O_3$ und 0,5 bis 12 % Gewichtsanteile Ni und/oder Co und/oder Fe und/oder deren Oxide enthält.

9. Wärmedämmschicht nach Anspruch 8,
    **dadurch gekennzeichnet,**
    **dass** der Stab ferner Kohlenstoff enthält.

10. Wärmedämmschicht nach Anspruch 1,
    **dadurch gekennzeichnet,**
    **dass** die homogene Oxidemischung, durch termisches Spritzen aufgebracht wird.

11. Wärmedämmschicht nach Anspruch 10,
    **dadurch gekennzeichnet,**
    **dass** die homogene Oxidemischung durch Plasmaspritzen aufgebracht wird.

12. Wärmedämmschicht nach Anspruch 1,
    **dadurch gekennzeichnet,**
    **dass** die homogene Oxidemischung durch ein Gasphasenabscheidungsverfahren aufgebracht wird.

13. Wärmedämmschicht nach Anspruch 12,
    **dadurch gekennzeichnet,**
    **dass** die homogene Oxidemischung durch ein plasmaunterstütztes Gasphasenabscheidungsverfahren aufgebracht wird.

14. Wärmedämmschicht nach einem der vorherigen Ansprüche,
    **dadurch gekennzeichnet,**
    **dass** sie ferner eine metallene Unterschicht aus einer aluminiumbildenden Legierung aufweist, die zwischen dem Substrat und der Oxidemischungs-Beschichtung angeordnet wird.

**15.** Wärmedämmschicht nach Anspruch 14,
**dadurch gekennzeichnet,**
**dass** es sich bei der Unterschicht um eine Beschichtung aus einer Nickel-Aluminiumverbindung handelt.

**16.** Wärmedämmschicht nach Anspruch 15,
**dadurch gekennzeichnet,**
**dass** die Nickel-Aluminiumverbindung mindestens ein Metall enthält, das unter Chrom, Edelmetallen und Platin(gruppen)erz, Yttrium und den seltenen Erden gewählt wird.

**17.** Wärmedämmschicht nach Anspruch 16,
**dadurch gekennzeichnet,**
**dass** es sich bei der Unterschicht um eine Beschichtung aus einer Legierung des Typs MCr AlY handelt, wobei M mindestens ein Metall bezeichnet, das unter Nickel, Kobalt und Eisen gewählt wird.

**18.** Metallenes Werkstück aus Superlegierung,
**dadurch gekennzeichnet,**
**dass** es eine Oberfläche aufweist, die mindestens teilweise mit einer Wärmedämmschicht mit niedriger spezifischer Wärmeleitfähigkeit nach einem der vorherigen Ansprüche beschichtet ist.

**19.** Verfahren zur Herstellung einer Wärmedämmschicht mit niedriger spezifischer Wärmeleitfähigkeit auf einem Substrat aus Superlegierung,
**dadurch gekennzeichnet,**
**dass** es darin besteht,

- ein pulveriges Gemisch aus Zirkonerde, einem die Zirkonerde stabilisierenden Oxid und einem zusätzlichen metallenen Element, und zwar Nickel, Kobalt oder Eisen, zu mischen und in Form eines Stabes zu sintern,
- das zu beschichtende Substrat in einen Raum für das EB-PVD-Beschichtungsverfahren einzuführen, in dem sich bereits der Stab befindet,
- den Raum unter Vakuum zu setzen, das Werkstück vorzuwärmen und Elektronenstrahlen dergestalt auf den Stab zu bündeln, dass die in dem Stab vorhandenen Elemente verdampft werden, damit sie sich auf dem zu beschichtenden Substrat niederschlagen.

**20.** Beschichtungsverfahren nach Anspruch 19,
**dadurch gekennzeichnet,**
**dass** bei der Herstellung des Stabes die Pulvermischung unter Verwendung eines Binders hergestellt wird, der ein mindestens teilweise organisches, kohlenstoffreiches Lösungsmittel enthält.

**21.** Beschichtungsverfahren nach Anspruch 20,
**dadurch gekennzeichnet,**
**dass** das Lösungsmittel ein Polyvinylalkohol ist.

**22.** Beschichtungsverfahren nach Anspruch 19,
**dadurch gekennzeichnet,**
**dass** es ferner darin besteht, in den Raum für das Beschichtungsverfahren in unmittelbare Nähe des zu beschichtenden Substrats einen Gasstrom einzuführen, der mindestens ein Gas enthält, das ein Zwischenstoff von Kohlenstoffist und durch Gasspaltung zersetzt werden kann.

**23.** Beschichtungsverfahren nach Anspruch 22,
**dadurch gekennzeichnet,**
**dass** das Gas, das ein Zwischenstoff von Kohlenstoff ist, aus den folgenden Gasen gewählt wird: Methan, Ethan, Butan, Propan, Alkengase und/oder Alkyngase.

**Claims**

**1.** Thermal barrier coating having a low thermal conductivity, deposited on a substrate made of super alloy, **characterized in that** it comprises a homogeneous mixture of oxides having a composition containing, at least, a zirconia base, a zirconia-stabilizing oxide and 0.5% to 12% by weight of an additional metal element chosen from nickel, cobalt, iron or a mixture of nickel and/or of cobalt and/or of iron, and **in that** it is deposited by EB-PVD.

2.  Coating according to Claim 1, **characterized in that** the proportion of additional metal element in the coating is between 1.5% and 5% by weight

3.  Coating according to either of Claims 1 and 2, **characterized in that** the additional metal element is introduced in oxidized form.

4.  Coating according to one of Claims 1 to 3, **characterized in that** the composition of the coating furthermore contains 0.01% to 1% by weight of carbon.

5.  Coating according to Claim 4, **characterized in that** the proportion of carbon in the coating is between 0.02% and 0.1% by weight.

6.  Coating according to Claim 1, **characterized in that** the zirconia-stabilizing oxide is yttria.

7.  Coating according to Claim 6, **characterized in that** the proportion of yttria is between 3% and 15%.

8.  Coating according to Claim 1, **characterized in that** the homogeneous mixture of oxides is deposited by an electron-beam evaporation process, by evaporating a bar having a composition comprising at least one base made of $Z_rO_2$, 3 to 15% by weight of $Y_2O_3$ and 0.5 to 12% of Ni and/or of Co and/or of Fe and/or of their oxides.

9.  Coating according to Claim 8, **characterized in that** the bar furthermore includes carbon.

10. Coating according to Claim 1, **characterized in that** the homogeneous mixture of oxides is deposited by thermal spraying.

11. Coating according to Claim 10, **characterized in that** the homogeneous mixture of oxides is deposited by plasma spraying.

12. Coating according to Claim 1, **characterized in that** the homogeneous mixture of oxides is deposited by a chemical vapour deposition process.

13. Coating according to Claim 12, **characterized in that** the homogeneous mixture of oxides is deposited by a plasma-enhanced chemical vapour deposition process.

14. Coating according to any one of the preceding claims, **characterized in that** it furthermore includes a metal underlayer made of an aluminide-forming alloy interposed between the substrate and the deposited layer of the oxide mixture.

15. Coating according to Claim 14, **characterized in that** the underlayer is a deposited layer of nickel aluminide.

16. Coating according to Claim 15, **characterized in that** the nickel aluminide includes at least one metal chosen from chromium, precious metals found in platinum ore, yttrium and rare earths.

17. Coating according to Claim 16, **characterized in that** the underlayer is a deposited layer of an alloy of the MCr AlY type in which M denotes at least one metal chosen from nickel, cobalt and iron.

18. Metal part made of a super alloy, **characterized in that** it has a surface coated at least partly with a thermal barrier coating according to any one of the preceding claims.

19. Process for depositing a thermal barrier coating having a low thermal conductivity on a substrate made of a super alloy, **characterized in that** it consists:

    -   in mixing and in sintering, into the form of a bar, a mixture of a zirconia powder, a powder of a zirconia-stabilizing oxide and a powder of an additional metal element chosen from nickel, cobalt and iron;
    -   in introducing the substrate to be coated into an EB-PVD deposition chamber precharged with the bar;
    -   in creating a vacuum in the chamber, in preheating the part and in focusing the electron beams onto the bar so as to vaporize the elements present in the bar in order for them to condense on the substrate to be coated.

20. Deposition process according to Claim 19, **characterized in that**, during production of the bar, the powder mixture is produced using a binder comprising an at least partially organic carbon-rich solvent.

21. Deposition process according to Claim 20, **characterized in that** the solvent is a polyvinyl alcohol.

22. Deposition process according to Claim 19, **characterized in that** it furthermore consists in introducing, into the deposition chamber in the immediate vicinity of the substrate to be coated, a gas stream containing at least one carbon precursor gas capable of being decomposed by cracking.

23. Deposition process according to Claim 22, **characterized in that** the carbon precursor gas is chosen from methane, ethane, butane, propane, a gas of the alkene family and/or a gas of the alkyne family.

Revêtements
selon l'art
antérieur

Revêtements
selon
l'invention

W/m.K

Température (°C)

**FIG : 1**

Revêtements
selon l'art
antérieur

Revêtements
selon
l'invention

W/m.K

Température (°C)

**FIG : 2**